# EUROPEAN PATENT APPLICATION

(11) **EP 1 231 628 A1**
(43) Date of publication of application: **14.08.2002**
(21) Application number: 01103005.3
(22) Date of filing: 08.02.2001
(51) Int. Cl.: H01L 21/02, H01L 21/8242

(54) **Method for roughening a surface of a semioconductor substrate**

(71) Applicant: Infineon Technologies SC300 GmbH & Co. KG, 01099 Dresden (DE)
(72) Inventor: Storbeck, Olaf, 01099 Dresden (DE); Kurtenbach, Andreas, 01099 Dresden (DE); Kuerner, Wolfgang, 01099 Dresden (DE)
(74) Representative: Fischer, Volker, Dipl.-Ing.

(57) **Abstract**

The present invention relates to a method for roughening a surface of a semiconductor substrate (1) comprising the steps of arranging the semiconductor substrate (1) in a furnace, providing a gas mixture comprising an inert gas and a halogen or a halogen-hydrogen compound in the furnace and providing a temperature between 700 and 1200°C in the furnace. The inventive method is capable of roughening the surface of a semiconductor substrate resulting in an increased capacitor area with an increased capacity.

## Description

The present invention relates to a method for roughening a surface of a semiconductor substrate.

In the technical field of semiconductor manufacturing it is well known to produce Dynamic Random Access Memories (DRAM) with memory cells comprising a selection transistor and a storage capacitor. The progress in semiconductor manufacturing is driven by the reduction of the feature size so that the number of functions arranged on a given area of a substrate can be increased. As the surface area for a single memory cell decreases, the capacity of the storage capacitor is decreasing as well. For proper operation of the memory cell a certain minimum capacity (in the order of 30 fF) for the storage capacitor is mandatory. If the capacity of the storage capacitor is too small, the charge stored in the storage capacitor is not sufficient to produce a detectable signal on the bit line when the selection transistor is opened. In this case the information stored in the memory cell is lost and the memory cell is not operating in the desired way.

Several ways are known in the state of the art to overcome the problem of shrinking feature size. For example, a storage capacitor is formed in a deep trench to maintain a large capacitor area with a high capacity while using a small surface of the substrate. Another method to create a capacitor with a high capacity is a stacked capacitor which is arranged on the surface of a semiconductor substrate, above the selection transistor. To increase the capacitor area it is known in the art to arrange hemispherical grains on the electrodes of the capacitor. The hemispherical grains result in an increased Capacitor area which increases the capacity. To build hemispherical grains it is known to deposit a polysilicon layer with a high roughness.

In view of the prior art it is an objective of the present invention to provide a method for roughening a surface of a semiconductor substrate in a way that the capacitor area is increased.

This objective is solved by a method for roughening a surface of a semiconductor substrate comprising the steps of:
- arranging the semiconductor substrate in a furnace;
- providing a gas mixture comprising an inert gas and a halogen gas or an inert gas and a halogen-hydrogen compound in the furnace;
- providing a temperature between 700 and 1200°C in the furnace.

Further advantages, features, abstracts and details of the invention are evident from the dependent claims.

The provided method therefore is applicable for example in DRAM technology for roughening the capacitor area of a storage capacitor. The inventive process is intended to produce pits in the capacitor area of the storage capacitor for enlarging the active area of the storage capacitor. This results in an increased storage capacity.

Advantageously, the invention increases the surface area and therefore the capacity of a storage capacitor.

According to an embodiment of the present invention, the inert gas comprises nitrogen, argon, helium or hydrogen.

According to another embodiment of the present invention the halogen comprises chlorine, bromine or fluorine, or halogen compound comprises hydrochloric acid, hydrobromic acid or hydrofluoric acid. Advantageously these halogens are capable of roughening the surface of a semiconductor substrate when used with the inventive method.

According to another embodiment,
- a trench is formed in the semiconductor substrate before the semiconductor substrate is arranged in the furnace and
- a capacitor is formed by arranging a dielectric layer and a conducting electrode in the trench after the semiconductor substrate was roughened in the furnace.

Advantageously the roughening of the surface of the semiconductor substrate can be combined with the manufacturing of a trench capacitor.

In a further embodiment of the invention, a stacked capacitor comprising a first and a second electrode is formed on the surface of the semiconductor substrate and one of the capacitor electrodes is roughened. This offers the possibility to increase the surface area of a stacked capacitor with the inventive surface roughening process.

In a further embodiment of the present invention the semiconductor substrate comprises silicon.

According to another embodiment a sacrificial oxide is grown thermally on the roughened surface of the semiconductor substrate.

According to another embodiment of the invention the sacrificial oxide is etched away from the surface of the semiconductor substrate. This process step is capable of smoothing the surface roughness and rounding etch holes. This leads to a well defined surface where electrical field enhancement on corners can be avoided, which could lead to electrical breakdown of thin dielectric layers.

The invention will be better understood with reference to the following description of embodiments of the invention taken in conjunction with the accompanying drawings, wherein:
- Figure 1: shows a surface roughened with the inventive process;
- Figure 2: shows a trench roughened with the inventive process;
- Figure 3: schematically illustrates a bottle shaped trench roughened with the inventive process;
- Figure 4: is a cross-section through an electrode of a stacked capacitor, roughened with the inventive process.

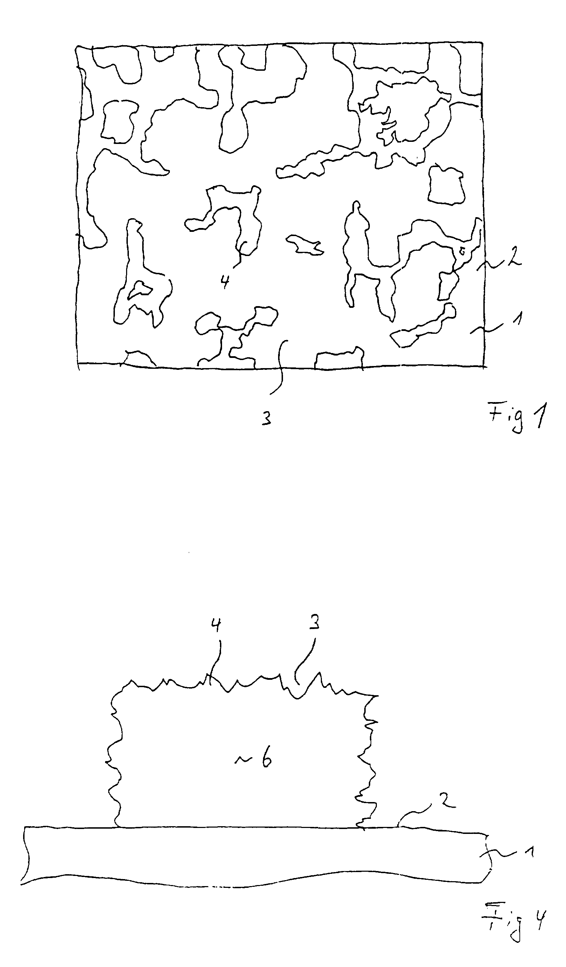

Figure 1 shows a surface of a roughened semiconductor substrate wherein the semiconductor substrate 1 can contain silicon. The surface 2 of the semiconductor substrate contains a pit 3 and a hillock 4. A method for roughening the semiconductor substrate 1 arranges the semiconductor substrate 1 in an atmospheric pressure batch furnace. The furnace is heated to a temperature between 700 and 1200°C and preferably heated to a temperature between 900 and 1100°C. As a carrier gas argon or nitrogen is introduced into the furnace. The pressure in the furnace is roughly atmospheric pressure. As a process gas for etching, 0.5% up to 10% hydrochloric acid is introduced into the furnace. For example, a process at 1000°C for thirty minutes in 2.5% hydrochloric acid with argon as the carrier gas at roughly atmospheric pressure is suitable for producing a roughened surface shown in figure 1. An other example for roughening the surface is performed at 1000°C for sixty minutes in 7.5% hydrochloric acid with argon as the carrier gas at roughly atmospheric pressure. For roughening the surface, tests have been performed with one semiconductor wafer in the boat of a batch furnace.

Additionally a small amount of water can be introduced into the furnace to support the roughening of the surface.

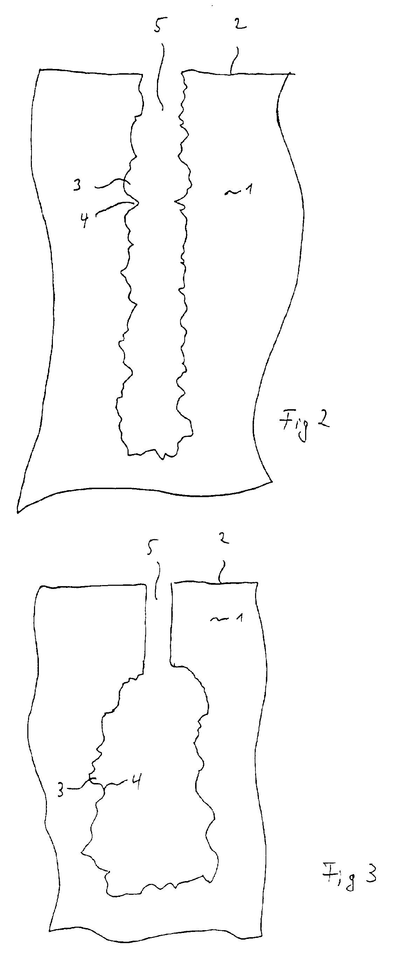

Figure 2 shows a trench 5 arranged in the semiconductor substrate 1 stretching from a surface 2 into the semiconductor substrate 1. The side wall of the trench 5 is roughened by the inventive process to produce a pit 3 and a hillock 4 on the side wall of the trench 5.

In figure 3 another embodiment of the invention with a bottle shaped trench is shown. The side wall of the trench 5 is roughened with the inventive process resulting in a pit 3 and a hillock 4 in the side wall of the trench 5.

In figure 4 a cross-section through a stacked capacitor electrode 6, arranged on a surface 2 of a semiconductor substrate 1, is shown. The stacked capacitor electrode 6 is roughened by the inventive process forming a pit 3 and a hillock 4.

To avoid electrical field enhancement in corners and hillocks the roughened surface can be smoothed by thermally growing a sacrificial oxide on the roughened surface 2 of the semiconductor substrate 1. The sacrificial oxide can be etched away from the surface of the semiconductor substrate 1. The sacrificial oxide can be etched with hydrofluoric acid if it comprises silicon oxide.

### List of References

- 1: Semiconductor substrate
- 2: Surface
- 3: Pit
- 4: Hillock
- 5: Trench
- 6: Stacked Capacitor Electrode

## Claims

1. A method for roughening a surface of a semiconductor substrate comprising the steps of:
- arranging the semiconductor substrate (1) in a furnace;
- providing a gas mixture comprising an inert gas and a halogen gas or an inert gas and a halogen-hydrogen compound in the furnace;
- providing a temperature between 700 and 1200°C in the furnace.

2. Method according to claim 1,
**characterised in that**
the inert gas comprises nitrogen, argon, helium or hydrogen.

3. Method according to one of the claims 1 or 2,
**characterised in that**
the halogen comprises chlorine, bromine or fluorine, or halogen compound comprises hydrochloric acid, hydrobromic acid or hydrofluoric acid.

4. Method according to one of the claims 1 to 3,
**characterised in that**
- a trench (5) is formed in the semiconductor substrate (1) before the semiconductor substrate (1) is arranged in the furnace and
- a capacitor is formed by arranging a dielectric layer and a conducting electrode in the trench after the semiconductor substrate (1) was roughened in the furnace.

5. Method according to one of the claims 1 to 3,
**characterised in that**
- a stacked capacitor comprising a first and a second electrode is formed on the surface (2) of the semiconductor substrate (1) and
- one of the capacitor electrodes is roughened.

6. Method according to one of the claims 1 to 5,
**characterised in that**
the semiconductor substrate (1) comprises silicon.

7. Method according to one of the claims 1 to 6,
**characterised in that**
a sacrificial oxide is grown thermally on the roughened surface (2) of the semiconductor substrate.

8. Method according to claim 7,
**characterised in that**
the sacrificial oxide is etched away from the surface of the semiconductor substrate (1).
